Europäisches Patentamt

European Patent Office

Office européen des brevets

(11) Numéro de publication : **0 280 630 B1**

# (12) FASCICULE DE BREVET EUROPEEN

(45) Date de publication du fascicule du brevet :
**06.05.92 Bulletin 92/19**

(51) Int. Cl.$^5$ : **C30B 25/00**, C30B 29/36

(21) Numéro de dépôt : **88420055.1**

(22) Date de dépôt : **18.02.88**

(54) **Procédé de préparation de trichites en carbure de silicium.**

(30) Priorité : **23.02.87 FR 8702528**

(43) Date de publication de la demande :
**31.08.88 Bulletin 88/35**

(45) Mention de la délivrance du brevet :
**06.05.92 Bulletin 92/19**

(84) Etats contractants désignés :
**AT BE CH DE ES GB GR IT LI LU NL SE**

(56) Documents cités :
**FR-A- 2 522 024**
**FR-A- 2 573 444**
**PATENT ABSTRACTS OF JAPAN, vol. 7, no.
232 (C-190)[1377], 14 octobre 1983; & JP-A-58
125 697 (TOUKAÏ CARBON K.K.)26-07-1983**
**PATENT ABSTRACTS OF JAPAN, vol. 8, no. 3
(C-203)[1440], 7 janvier 1984; & JP-A-58 172
297 (TOUKAÏ CARBON K.K.) 11-10-1983**

(73) Titulaire : **PECHINEY ELECTROMETALLURGIE
Tour Manhattan La Défense 2 6 Place de l'Iris
F-92400 Courbevoie (FR)**

(72) Inventeur : **Dubots, Dominique
61 rue des Alpes Passy-Chedde
F-74190 Le Fayet (FR)**
Inventeur : **Dubrous, Françis
451 route du Fayet
F-74700 Sallanches (FR)**

(74) Mandataire : **Vanlaer, Marcel et al
PECHINEY 28, rue de Bonnel
F-69433 Lyon Cédex 3 (FR)**

EP 0 280 630 B1

Jouve, 18, rue Saint-Denis, 75001 PARIS

## Description

## DOMAINE TECHNIQUE DE L'INVENTION

La présente invention concerne un procédé de préparation de trichites de carbure de silicium à partir de silice et de carbone à l'état finement divisés.

## ETAT DE LA TECHNIQUE ANTERIEURE

Les trichites (parfois appelées "whiskers") sont des fibres monocristallines fines, de carbure de silicium dont le diamètre peut aller de 0,1 à 5 micromètres selon les conditions opératoires et la longueur de quelques dizaines à quelques centaines de micromètres, et dont la couleur va de l'incolore au vert pâle. Elles se caractérisent par des propriétés mécaniques remarquables (charge de rupture 4 à 12 GPa/module d'élasticité 300 à 700 GPa), une grande stabilité chimique et une résistance élevée à la chaleur, qui en font un matériau de choix pour le renforcement des matériaux métalliques ou plastiques, par exemple de l'aluminium et de ses alliages.

La préparation des trichites fait appel à la réaction de silicium, sous forme de silice et de carbone sous une forme très divisée. Ce type de réaction est étroitement dépendant de facteurs tels que la source de silicium, la nature du carbone, les procédures de mélange, les éventuels adjuvants (catalyseurs et/ou agents porogènes), l'atmosphère et la température en chaque point de la charge réactionnelle.

La demande de brevet français FR-A-2 573 444 (TOKAI CARBON Co Ltd) décrit un procédé de fabrication de trichites de SiC consistant à chauffer un mélange de noir de carbone et une source de silicium (sable, silex, gel de silice ...) sous atmosphère non oxydante à une température de 1300 à 1800°C. Le carbone utilisé doit avoir une surface spécifique d'absorption d'azote de 150 à 500 $m^2/g$, un taux d'absorption du DBP (dibutylphtalate) de 120 à 200 ml par 100 g et une intensité de teinte déterminée. Le catalyseur est à base de fer, de nickel ou de cobalt.

Dans la demande de brevet français FR-A-2.567.873 (Nippon Light Metal Co Ltd), on décrit également un procédé d'obtention de trichites de SiC à partir de poudre de carbone et de poudre de $SiO_2$, le mélange ayant une densité apparente non supérieure à 0,23, procédé selon lequel le mélange est chauffé en atmosphère de gaz inerte, entre 1500 et 2000°C.

Ces procédés restent encore expérimentaux. Pour produire des trichites de SiC convenant, par leur structure, leurs caractéristiques et leur prix de revient à l'usage industriel, il est nécessaire de disposer d'un procédé capable de produire ces trichites avec le minimum d'accidents morphologiques tels que les agrégats, avec des longueurs de l'ordre de 50 à 200 µm, et des diamètres inférieurs à 5 µm, et un rendement élevé en trichites par rapport à la charge de $SiO_2$ + C.

On peut également citer la demande FR-A-2.522.024 (Tokai Carbon), dans laquelle des trichites de carbure de silicium sont préparées à partir d'un mélange de 100 parties en poids de gel de silice contenant un catalyseur sous forme d'un composé soluble dans l'eau, et de 110 à 400 parties en poids de noir de carbone ayant un certain indice d'absorption de DBP (dibutylphtalate), par chauffage en atmosphère non oxydante à une température comprise entre 1300 et 1700°C, une température de 1600°C étant exemplifiée. Le catalyseur est choisi parmi Fe, Ni, Co.

## OBJET DE L'INVENTION

L'objet de l'invention est un procédé de production de trichites de SiC, à partir d'un mélange de noir de carbone et, dans un rapport pondéral au moins égal à la stoëchiométrie de la réaction $SiO_2 + 3\ C \rightarrow SiC + 2CO$ (soit $C/SiO_2 = 0,6$), d'une source d'oxyde de silicium ayant une granulométrie inférieure à 100 µm, par chauffage en atmosphère non oxydante à une température d'environ 1600°C.

Ce procédé est caractérisé en ce que le noir de carbone utilisé doit avoir un taux d'oxydabilité au moins égal à 85%, l'oxydabilité étant définie par la perte de poids du carbone considéré lorsqu'il est chauffé à 600°C durant 30 min. à l'air libre.

Ce procédé est aussi caractérisé en ce que la vitesse de montée en température du mélange réactionnel doit être au plus égale à 3°C/$min^{-1}$ si l'on opère en atmosphère statique. Si l'on opère sous percolation d'azote, définie par un débit compris entre 0,05 et 0,5 normolitre par minute et par $cm^2$ de charge traversée, la vitesse de montée en température de la même charge doit être au plus égale à 25°C/$min^{-1}$.

Il est avantageux d'ajouter au mélange noir de carbone-silice un agent porogène qui maintienne la perméabilité de la charge aux gaz. Les espaces vides ainsi créés permettent une ventilation de la charge par les espèces gazeuses réactives nécessaires à la croissance des trichites dans ces volumes non occupés par des solides.

De même, pour faciliter le transfert homogène des produits gazeux contenant les espèces réactives (essentiellement le monoxyde de silicium et le monoxyde de carbone), dont les concentrations doivent être en adéquation avec la température d'après la thermodynamique, il est utile de procéder pendant la réaction à une percolation de la charge par un gaz tel que l'azote (à défaut d'une percolation, un léchage ou un balayage par un gaz à faible vitesse reste favorable).

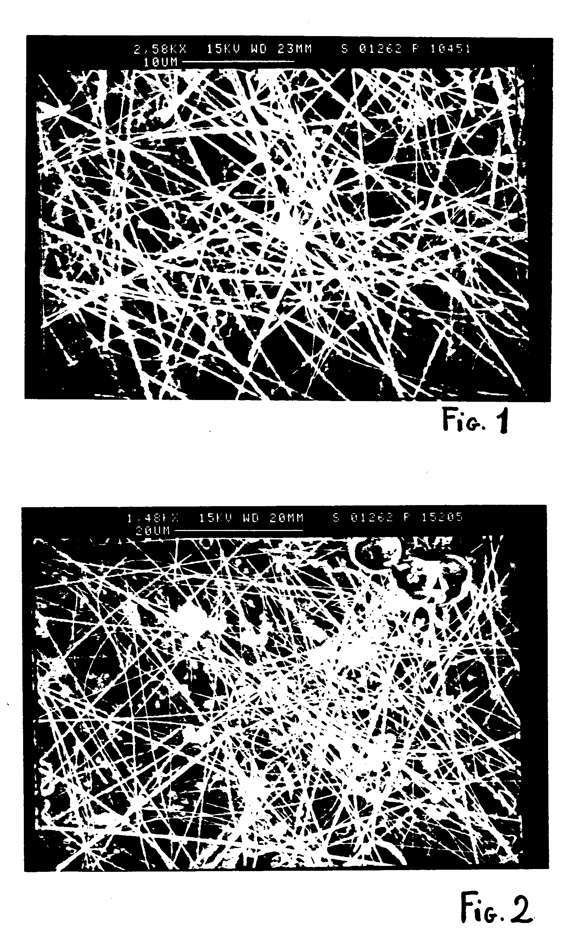

Les figures 1 et 2 sont des photographies en microscopie électronique à balayage de produits de réaction. La figure 1 (grandissement 3000) représente un cocon de trichites de très bonne qualité. La figure 2 (grandissement 1500) représente, au contraire, le résultat d'essais en dehors des limites de l'invention. On aperçoit de nombreux agrégats et accidents morphologiques sur les fibres obtenues.

Les conditions de mise en oeuvre du procédé peuvent être séparées en trois parties : la préparation du mélange silice-carbone, additifs éventuels, la réaction proprement dite et la récupération des trichites.

### 1- Préparation du mélange :

La première caractéristique du procédé est que les réactants (silice et carbone) doivent être mélangées à sec, et que le mélange résultant ne doit pas être tassé. Un moyen pour remplir cette condition consiste à utiliser un mélangeur turbulent, muni de couteaux émotteurs, qui possède la caractéristique de ne pas tasser le mélange. La densité apparente du mélange est donc fonction des matières premières et peut atteindre 0,40.

Choix des matières premières

– Silice : on a utilisé des silices de provenance diverses : silice ultrafine provenant du dépoussiérage de fours électro-métallurgiques produisant du silicium ou du ferro-silicium, de fours électriques de fusion de sable de zircon (silicate de zirconium). Ces poussières contiennent au moins 85 % de $SiO_2$ sous forme de billes de diamètre moyen inférieur à 1 $\mu$m. Les impuretés sont constituées de matières organiques volatiles, de carbone, de carbure de silicium, de composés de Fe, Al, Mg, Ca, Na, K. Peuvent également convenir la silice précipitée, du quartz ou du sable broyés, du verre blanc broyé. Toutes ces qualités de silice conviennent à condition d'être tamisées sur un tamis à maille au plus égale à 100 $\mu$m.

– carbone : la nature du carbone est un facteur essentiel pour la mise en oeuvre de l'invention. De façon générale, le produit utilisé doit appartenir à la classe des produits dits "noirs de carbone", obtenus soit par combustion incomplète soit par dissociation thermique de combinaisons hydrocarbonées. En pratique, ces combinaisons hydrocarbonées sont du gaz naturel, de l'acétylène, des huiles minérales, des huiles de goudron. Ces produits se caractérisent en particulier :

– par une dimension de particules de l'ordre de 5 à 50 manomètres,

– par une teneur en carbone de l'ordre de 95 à 99 %, le reste étant de l'hydrogène, de l'oxygène, de l'azote, du soufre,

– par une surface spécifique BET très élevée, de l'ordre de 10 à 1000 $m^2$ par gramme,

– par une adsorption DBP (dibutylphtalate) de l'ordre de 50 à 200 ml/100 g,

– par un index nigrométrique (profondeur de noir), mesuré par adsorption de lumière absorbée et réfléchie.

Les fabricants de ces divers types de noirs (noir de furnace, noir d'acétylène, noir de gaz, etc) indiquent en outre d'autres caractéristiques particulières selon l'usage envisagé (pigments pour encres et peintures, charge de caoutchouc ou plastique) qui ne présentent pas d'intérêt dans le cas présent.

Toutefois, la demanderesse a constaté que le facteur essentiel et qui ne figure pas dans les spécifications des fabricants de noir de carbone, était la réactivité du produit, et, plus précisément son oxydabilité, que l'on a définie ci-dessus.

Les exemples de mise en oeuvre qui seront donnés confirmeront le caractère essentiel de ce test de sélection des noirs de carbone.

- Catalyseurs et additifs :

Compte tenu de la sélection du carbone par sa réactivité, l'introduction des catalyseurs classiques (Fe, Ni, Co) n'a pas été nécessaire pour la mise en oeuvre de l'invention. Toutefois, la présence accidentelle de ces métaux ainsi que de composés de métaux alcalins a un effet plutôt favorable, notamment les composés de sodium qui, de plus, ont une action sur le taux d'oxydabilité du noir de carbone en favorisant la formation de composés plus réactifs.

L'introduction d'un agent porogène permet d'améliorer très sensiblement le rendement et l'efficacité de la réaction. On l'introduit dans le mélange C + $SiO_2$, dans une proportion pouvant aller à 5 à 50 % en volume.

Cet agent s'élimine sous forme de gaz et/ou de vapeur, juste avant ou pendant le démarrage de la réaction et il favorise ainsi la formation d'une masse très poreuse de trichites enchevêtrées (cocon), en permettant l'obtention d'une masse réactionnelle de grande porosité distribuée de manière homogène offrant ainsi une plus faible perte de charge aux gaz et peu de trajets préférentiels aux espèces gazeuses réactives diluées. C'est la ventilation homogène des solides de la masse réactionnnel par ces gaz nourrissiers qui permet une croissance homogène des trichites dans les porosités de cette masse solide.

Parmi les agents porogènes essayés, la demanderesse a constaté que les composés minéraux (du type NaCl, NH$_4$Cl) n'étaient pas très favorables car ils semblent mouiller ou imprégner les réactants et induire des réactions parasites se traduisant par des trichites difformes et par la formation de grains et agrégats.

Par contre, les composés organiques ne générant que peu de goudrons, du type farines de bois, liège, amidons, mélamine, balle de riz, apparaissent comme très favorables. Il convient de distinguer deux types d'agents porogènes répondant aux contraintes du procédé.

– ceux qui se subliment ou se décomposent intégralement sans laisser de résidus, par exemple la mélamine,

– ceux qui laissent des résidus tels que centres ou cokes et pour lesquels la granulométrie doit être choisie de manière à pouvoir éliminer ces résidus contenant des impuretés par des méthodes classiques telles que oxydation à basse température, flottation, tamisage de suspension, décantation.

## 2. Mise en oeuvre de la réaction

La réaction est mise en oeuvre sur un mélange de SiO$_2$ passant entièrement au tamis de 100 μm, de noir de carbone réactif, et éventuellement de 5 à 50%, en volume, d'agent porogène.

Le noir de carbone est introduit de préférence en quantité surstoechiométrique : au moins 70 parties en poids de noir de carbone pour 100 parties en poids de silice (rapport 0,7). Si l'on admet que la réaction globale est :

$$SiO_2 + 3\,C \rightarrow SiC + 2\,CO$$

il faut 60 g de Noir de Carbone (compté à 100 % en poids de carbone) pour 100 g de silice (comptée à 100 % en poids de SiO$_2$), soit un rapport de 0,6. Il faut également tenir compte dans le calcul de la présence éventuelle d'impuretés oxydées réductibles par le carbone : par exemple Na$_2$O si la source de SiO$_2$ est un verre broyé.

La surstoechiométrie en Noir de Carbone, si elle est écononiquement défavorable, favorise la dispersion ultérieure des trichites formant le cocon.

Le mélange intime noir de C + SiO$_2$ + éventuel agent porogène ne doit pas être tassé, comme on l'a indiqué précédemment. Sa masse volumique apparente peut se situer par exemple entre un peu moins de 0,20 et 0,40 gramme par centimètre cube, selon la source de silice utilisé (qualité et répartition granulométrique), le noir et les éventuels adjuvants.

## - Chauffage

La demanderesse a constaté -et c'est là un autre élément essentiel de l'invention que l'un des facteurs fondamentaux dans la synthèse des trichites est la vitesse de montée en température qui justement contrôle cette cinétique subtile de croissance gazeuse des mono-cristaux de SiCβ suivant un axe préférentiel.

La réaction démarre entre 1300°C et 1400°C et l'aspect le plus important de l'invention consiste justement à contrôler de façon continue la température imposée à la masse réactionnelle de manière à ne jamais devancer la consommation des réactifs gazeux par le processus de croissance cristalline des trichites en maintenant un gradient de température dans la masse.

La demanderesse a aussi constaté l'importance des facteurs volume de mélange et position des flux de chaleur par rapport aux surfaces du volume constitué par la masse réactionnelle. Il a aussi été établi qu'un flux de chaleur provenant de l'extérieur de la charge est favorable à la formation de trichites.

Les produits de la réaction sont des isolants thermiques, si bien que les premières couches de réactants transformés diminuent la vitesse de passage du flux thermique en jouant le rôle d'écran thermique. Cet effet ralentit donc la vitesse de montée en température de la masse réactionnelle, ce qui est un facteur favorable à la formation de Sic sous forme de trichites. Une montée rapide se traduit donc par la formation d'une couche écran extérieure d'épaisseur fonction de cette vitesse de montée en température et constituée essentiellement de particules n'ayant pas la morphologie des trichites. L'épaisseur de cette couche peut réduire notablement l'efficacité de l'opération sur le plan du rendement (quantité de trichites formées).

Lorsque la température maximale de la charge a été atteinte -soit environ 1600°C, on peut couper le chauffage et laisser refroidir la masse réactionnelle, dans la mesure où l'on a opéré sur de petits volumes et sur une silice très réactive, à fine granulométrie. Si ce n'est pas le cas -masse réactionnelle de plusieurs centaines de grammes à plusieurs kg ou dizaines de kg- et/ou utilisation d'une silice moins réactive (verre broyé par exemple), on effectue un palier à la température maximale (environ 1600°C par exemple), d'une durée de 5 minutes à 5 heures, puis on coupe le chauffage et on laisse refroidir la charge. Si l'on a opéré sous percolation d'azote, on maintient un courant d'azote, éventuellement réduit, pendant au moins une partie du refroidissement.

Après le traitement thermique de la masse réactionnelle, les trichites de carbure de silicium forment un cocon dont la porosité et la tenue mécanique dépendent de la densité apparente du mélange réactionnel, plus exactement de son degré de tassage ou de compaction et de la proportion de noir de carbone.

Si cette masse se développe à partir de toute la surface extérieure du volume réactionnel et progresse vers l'intérieur, il arrive qu'une partie du mélange réactionnel se trouve enfermée par une épaisse enveloppe de trichites enchevêtrées. La réaction de formation du carbure de silicium à partir de silice et de carbone, générant d'importantes quantités d'une espèce gazeuse : le monoxyde de carbone. Il est nécessaire que ce gaz soit éliminé sans pertes de charge trop importantes pour maintenir une pression interne faible. Il arrive que dans le coeur du cocon, cette condition n'ait pas été remplie du fait de la position respective des flux de chaleur et de la masse réactionnelle, ou de l'absence (ou de l'insuffisance) d'agent porogène.

La demanderesse a constaté que dans ce cas, il est facile d'éliminer ce coeur du cocon car il présente une consistance et une couleur différentes de l'épaisse couche de trichites enchevêtrées qui l'enferme.

La demanderesse a aussi constaté que ce phénomène pouvait être réduit par percolation d'un gaz tel que l'azote qui semble favoriser la croissance des trichites vraisemblablement en permettant la formation transitoire de composés azotés intermédiaires.

Lorsqu'ont été modifiées les positions respectives de la source de chaleur et de la masse réactionnelle en utilisant des susceptors ou des résistors placés au centre ou dans l'axe de la charge, il n'a pas été possible d'obtenir la quantité habituelle de trichites sous la forme d'un cocon. Il semblerait que les trichites croissent dans une zone chaude à partir d'espèces gazeuses générées dans une zone plus froide, c'est-à-dire à partir d'espèces gazeuses dans des proportions (ou pressions partielles) ne correspondant pas à celles de l'équilibre thermodynamique calculé dans la zone chaude de croissance des trichites.

### 3. Séparation des trichites

La séparation des trichites du cocon formé constitue le dernier stade du procédé objet de la présente invention.

Le produit de la réaction est obtenu sous forme d'un cocon formé de deux zones aisément séparables :
– une enveloppe extérieure d'épaisseur variable suivant les conditions opératoires et constituées presqu'exclusivement de trichites de carbure de silicium et de noir de carbone excédentaire,
– une partie centrale sans grande tenue mécanique et constituée presqu'exclusivement d'une poudre contenant des particules de carbure de silicium, du noir de carbone excédentaire et quelques trichites. Il est connu que ce noir de carbone peut être éliminé par chauffage à l'air entre 500 et 700°C.

## EXEMPLES DE MISE EN OEUVRE

On a mis l'invention en oeuvre dans un four électrique à résistor tubulaire en graphite, horizontal, de 200 mm de diamètre intérieur, balayé à l'azote (3 litres/minute).

La charge réactionnelle est disposée dans un creuset en graphite, percé d'évents, de 120 mm de diamètre intérieur et de 500 mm de long, rempli au maximum aux 2/3 par le mélange réactionnel et disposé dans la zone de température homogène du four.

### Exemple 1

Le mélange de départ est composé de :
– 48 % en poids de carbone FW2V provenant de la Sté DEGUSSA, ayant un BET de 460 m$^2$g$^{-1}$, un taux d'oxydation de 87 % et un indice de matières volatiles de 16 % en poids
– 52 % en poids de silice micronique provenant du dépoussiérage de fours à silicium : 52 % (en poids)
Masse volumique du mélange : 0,20 g/cm$^3$
– Conditions :
Montée en température de l'ambiante à 1000°C en 2 h (500°C.h$^{-1}$)
Montée de 1000 à 1300°C en 3 h (100°C.h$^{-1}$), et de 1300 à 1600°C en 8 h (50°C.h$^{-1}$, soit < 1°.min$^{-1}$)
Refroidissement naturel, sous balayage d'azote. On extrait du creuset froid le cocon qui est coupé en deux selon son axe.
On procède alors à l'oxydation du carbone résiduel par chauffage à l'air à 600°C pendant une durée qui dépend de l'oxydabilité du noir de carbone utilisé.

Les différentes zones du cocon sont ensuite séparées en fonction de leur couleur et de leur consistance mécanique.

Dans ce premier exemple, on a obtenu un cocon de trichites de très bel aspect, avec des fibres de diamètre inférieur à 5 micromètres, une longueur moyenne de 20 à 100 μm, et une très faible proportion d'espèces morphologiquement indésirables, identiques à celles de la figure 1.

Exemple 2

On a opéré dans les mêmes conditions que pour l'Exemple 1 en remplaçant la silice micronique par du verre blanc broyé et tamisé, passant au tamis de 100 μm avec une teneur totale Na + K d'environ 15 % et 0,6 de $Fe_2O_3$ provenant du broyage et moins de 5 % (en poids) de bore (à l'état de composé).

Le mélange est constitué dans les proportions suivantes :

```
- verre blanc broyé ..................... 58 % en poids
- noir de carbone ....................... 42 % en poids
- Masse volumique du mélange ............ 0,33 g.cm⁻³
```

On a utilisé pour cette série d'essais du noir de carbone FW2V de DEGUSSA comme dans l'exemple 1, et du Printex 85 DEGUSSA, surface BET 200 $m^2.g^-$ taux d'oxydabilité 87 % en poids (30 min/600°C), avec des résultats pratiquement identiques.

Cette formulation donne également des cocons de très bel aspect, avec des fibres de diamètre inférieur à 5 μm, de 20 à 100 μm de long (identiques à ceux de la figure n° 1).

Exemple 3

Mêmes conditions que dans les exemples 1 et 2.

Le mélange comporte :

```
- poussière de silice micronique (ex-four à Si) ... 29 %
- Printex 85 .................................... 21 %
- Mélamine (agent porogène) ..................... 50 %
- Masse volumique apparente ..................... 0,4 g.cm⁻³
```

Résultat : très bons, comme dans les exemples 1 et 2.

Exemple 4

Mêmes conditions que dans l'exemple 1, mais on a fixé la vitesse de montée en température entre 1300 et 1500°C à 20°C/min, et procédé à une percolation d'azote au travers de la charge, à un débit de 0,15 normolitre/min et par $cm^2$ de section transversale du four, un palier de températures de 2 heures ayant été réalisé à 1600°C.

On a obtenu un cocon de très belles trichites, alors que le même essai, effectué sans percolation d'azote, n'a donné que des bâtonnets de SiC épais et courts mélangés à des agrégats de cristaux de SiC, inutilisables pour la réalisation de composites à matrices métalliques.

Exemple 5 (comparatif)

Mêmes conditions que dans l'exemple 1, mais le mélange a été homogénéisé dans de l'alcool éthylique. Masse volumique apparente : 0,7 g.cm⁻³ après évaporation de l'alcool.

Résultat : le produit final est inutilisable : on n'obtient que quelques rares trichites enrobées dans un agrégat de grains de SiC.

Exemple 6 (comparatif)

Mêmes conditions que dans l'exemple 1, mais le noir de carbone a un taux d'oxydabilité de 70 % (30 min/600°C/air).

Résultat : cocon de trichites mêlées de produits morphologiquement indésirables, dont la séparation reste possible, mais qui réduisent fortement le rendement en produit utilisable (photo n°2).

Exemple 7 (comparatif)

Mêmes conditions que dans l'exemple 1, mais le noir de carbone a un taux d'oxydabilité de 15 %.
Résultat : on n'obtient que peu de trichites de SiC dispersées dans un agrégat d'où il est difficile de les extraire.

Exemple 8 (comparatif)

Mêmes conditions que dans l'exemple 1, mais le régime de montée en température a été modifié.
La température est élevée de 1000°C à 1600°C par intervalle de 100°C en faisant des paliers de 30 à 60 mm et en appliquant entre chaque palier des vitesses de montée en température de 10°C/min dans un premier essai, 20°C/min dans un deuxième essai, 30°C/min dans un troisième essai. Ces trois essais ayant été réalisés sans percolation d'azote.
Dans les trois cas, les résultats ont été médiocres : trichites hétérogènes (en longueur et diamètre), proportion importante de grains et aggrégats.
Il se confirme donc que les conditions revendiquées constituent des limites hors desquelles on n'obtient pas de résultats satisfaisants.

**Revendications**

1. Procédé de préparation de trichites de carbure de silicium par réaction, en atmosphère non oxydante, à une température d'environ 1600°C d'une charge constituée d'un mélange de noir de carbone et, dans un rapport pondéral au moins égal à la stoëchiométrie de la réaction $SiO_2 + 3C \rightarrow SiC + 2CO$ (soit $C/SiO_2 = 0,6$), d'une source d'oxyde de silicium ayant une granulométrie inférieure à 100 µm caractérisé en ce que le noir de carbone a un taux d'oxydabilité, mesuré par perte de poids par chauffage à l'air à 600°C pendant 30 minutes, au moins égal à 85%, et en ce que l'on chauffe le mélange avec une vitesse de montée en température, entre 1300 et 1600°C, au plus égale à 3°C/min$^{-1}$ si l'on opère en atmosphère statique et au plus égale à 25°C/min$^{-1}$ si l'on opère sous percolation d'azote, le chauffage étant réalisé de façon à apporter les calories de l'extérieur du mélange.

2. Procédé selon revendication 1, caractérisé en ce que le rapport pondéral $C/SiO_2$ est au moins égal à 0,7.

3. Procédé, selon revendications 1 ou 2, caractérisé en ce que l'on effectue un palier de température à environ 1600°C pendant une durée comprise entre 5 minutes et 5 heures.

4. Procédé selon l'une quelconque des revendications 1 à 3, caractérisé en ce que la charge comprend, en outre, un agent porogène organique.

5. Procédé selon l'une quelconque des revendications 1 à 4, caractérisé en ce que la percolation de gaz est réalisée à une vitesse comprise entre 0,05 et 0,5 normolitre par minute et par cm$^2$ de section de la charge traversée.

6. Procédé selon l'une quelconque des revendications 1 à 5, caractérisé en ce que le gaz de percolation est de l'azote.

7. Procédé selon l'une quelconque des revendications 1 à 6, caractérisé en ce que la source de silice est constituée de poussières de silice issues du dépoussiérage de fours de fabrication carbothermique du silicium ou du ferro-silicium ou des fours électriques de fusion de sable de zircon, ces poussières contenant au moins 85 % de silice sous forme de billes dont le diamètre moyen est inférieur à 1 µm.

8. Procédé selon l'une quelconque des revendications 1 à 7 caractérisé en ce que la source de silice utilisée est constituée d'un verre pilé dont les dimensions des particules sont inférieures à 100 µm et contenant plus de 10 % en poids de composés alcalins (en particulier du sodium) et moins de 5 % en poids de bore (sous forme de composé).

9. Procédé selon l'une quelconque des revendications 1 à 8, caractérisé en ce que le noir de carbone excédentaire est éliminé de l'enveloppe par oxydation à l'air entre 500 et 700°C pendant une durée de 1 à 10 heures.

EP 0 280 630 B1

## Claims

1. A process for the preparation of silicon carbide whiskers by reaction in a non-oxidising atmosphere at a temperature of about 1600°C of a charge constituted by a mixture of carbon black and, in a ratio by weight at least equal to the stoichiometry of the reaction $SiO_2 + 3 C \rightarrow SiC + 2 CO$ (that is $C/SiO_2 = 0.6$), of a source of silicon oxide having a grain size of less than 100 µm, characterised in that the carbon black has on oxidability rate, measured by weight loss by heating in air at 600° C for 30 minutes, of at least 85 %, and in that the mixture is heated at a rate of rise in temperature at between 1300 and 1600°C of at most $3°C.min^{-1}$ if a static atmosphere prevails and at most $25°C.^{-1}$ if nitrogen percolation is effected, heating being carried out in order to contribute calories from the exterior of the mixture.

2. A process according to Claim 1, characterised in that the ratio by weight of $C/SiO_2$ is at least 0.7.

3. A process according to Claims 1 or 2, characterised in that a temperature stage at about 1600°C is carried out for a period of between 5 minutes and 5 hours.

4. A process according to any one of Claims 1 to 3, characterised in that the charge also contains an organic foaming agent.

5. A process according to any one of Claims 1 to 4, characterised in that gas percolation is carried out at a rate of between 0.05 and 0.5 normolitre per minute and per $cm^2$ of cross-section of the traversed charge.

6. A process according to any one of Claims 1 to 5, characterised in that the percolation gas is nitrogen.

7. A process according to any one of Claims 1 to 6, characterised in that the source of silica is made up of silica dust collected during removal of dust from furnaces for the carbothermic production of silicon or ferro-silicon or from electric, zircon sand fusion furnaces, this dust containing at least 85% of silica in the form of beads having an average diameter of less than 1 µm.

8. A process according to any one of Claims 1 to 7, characterised in that the source of silica used is composed of a glass frit, the particle size of which is less than 100 µm, which contains more than 10% by weight of alkaline compounds (in particular sodium) and less than 5% by weight of boron (in compound form).

9. A process according to any one of Claims 1 to 8, characterised in that the excess carbon black is removed from the casing by oxidation in air at between 500 and 700°C for a period of from 1 to 10 hours.


## Patentansprüche

1. Verfahren zur Herstellung von Siliziumcarbid-Whiskern durch Reaktion einer Charge, die aus einer Mischung von Ruß und, in einem Gewichtsverhältnis von wenigstens gleich der Stöchiometrie der Reaktion $SiO_2 + 3 C \rightarrow SiC + 2 CO$ (d.h. $C(SiO_2 = 0,6)$, einer Quelle von Siliziumoxid mit einer Korngröße unter 100 µm besteht, in nichtoxidierender Atmosphäre bei einer Temperatur von etwa 1600 °C, dadurch **gekennzeichnet**, daß der Ruß einen Oxidierbarkeitsgrad, gemessen durch Gewichtsverlust infolge Erhitzung an der Luft auf 600 °C während 30 Minuten, von wenigstens gleich 85 % hat, und daß man die Mischung mit einer Temperaturanstiegsgeschwindigkeit zwischen 1300 und 1600 °C von höchstens gleich 3 °C/min, wenn man in statischer Atmosphäre arbeitet, und höchstens gleich 25 °C/min erhitzt, wenn man unter Stickstoffspülung arbeitet, wobei die Erhitzung derart erfolgt, um die Wärme außerhalb der Mischung zuzuführen.

2. Verfahren nach Anspruch 1, dadurch gekennzeichnet, daß das Gewichtsverhältnis $C/SiO_2$ wenigstens gleich 0,7 ist.

3. Verfahren nach Anspruch 1 oder 2, dadurch gekennzeichnet, daß man eine Temperaturstufe bei etwa 1600 °C während einer Dauer von 5 Minuten bis 5 Stunden vorsieht.

4. Verfahren nach irgendeinem der Ansprüche 1 bis 3, dadurch gekennzeichnet, daß die Charge außerdem ein organisches Porenbildungsmittel enthält.

5. Verfahren nach irgendeinem der Ansprüche 1 bis 4, dadurch gekennzeichnet, daß die Gasspülung mit einer Geschwindigkeit im Bereich von 0,05 bis 0,5 Normalliter je Minute und je $cm^2$ des Querschnitts der durchströmten Charge durchgeführt wird.

6. Verfahren nach irgendeinem der Ansprüche 1 bis 5, dadurch gekennzeichnet, daß das Spülgas Stickstoff ist.

7. Verfahren nach irgendeinem der Ansprüche 1 bis 6, dadurch gekennzeichnet, daß die Siliziumoxidquelle aus Siliziumoxidstäuben besteht, die von der Entstaubung von Öfen zur carbothermischen Erzeugung des Siliziums oder des Ferrosiliziums oder von elektrischen Öfen zum Schmelzen von Zirkonsand stammen, welche Stäube wenigstens 85 % Siliziumoxid in Form von Kügelchen enthalten, deren mittlerer Durchmesser unter 1 µm ist.

8. Verfahren nach irgendeinem der Ansprüche 1 bis 7 (6!), dadurch gekennzeichnet, daß die verwendete Siliziumoxidquelle aus einer Glasurmasse besteht, deren Abmessungen der Teilchen unter 100 µm sind und die mehr als 10 Gew.% Alkaliverbindungen (insbesondere des Natriums) und weniger als 5 Gew.% Bor (in Verbindungsform) enthält.

9. Verfahren nach irgendeinem der Ansprüche 1 bis 8, dadurch gekennzeichnet, daß der überschüssige Ruß von der Hülle durch Oxidation an der Luft zwischen 500 und 700 °C während einer Dauer von 1 bis 10 Stunden entfernt wird.

Fig. 1

Fig. 2